# DEMANDE DE BREVET EUROPEEN

(11) **EP 3 079 168 A1**
(43) Date de publication de la demande: **12.10.2016**
(21) Numéro de dépôt: 16164185.7
(22) Date de dépôt: 07.04.2016
(51) Int. Cl.: H01L 21/8234, H01L 29/66, H01L 29/786, H01L 29/417, H01L 21/8238

(54) **PROCÉDÉ DE DOPAGE DES RÉGIONS DE SOURCE ET DE DRAIN D'UN TRANSISTOR À L'AIDE D'UNE AMORPHISATION SÉLECTIVE**

(30) Priorité: 09.04.2015 FR 1553049
(71) Demandeur: Commissariat à l'Énergie Atomique et aux Énergies Alternatives, 75015 Paris (FR)
(72) Inventeur: REBOH, Shay, 38054 GRENOBLE (FR); BATUDE, Perrine, 21000 DIJON (FR); MAZEN, Frédéric, 38120 SAINT EGREVE (FR); SKLENARD, Benoit, 38100 GRENOBLE (FR)
(74) Mandataire: Brevalex

(57) **Abrégé**

Procédé comprenant des étapes consistant à :
- former des blocs semi-conducteurs de source et de drain comportant une première couche à base d'un premier matériau semi-conducteur cristallin surmontée d'une deuxième couche (16) à base d'un deuxième matériau semi-conducteur cristallin différent du premier matériau semi-conducteur,
- rendre amorphe et doper sélectivement la deuxième couche (16) à l'aide d'une ou plusieurs implantation(s),
- effectuer une recristallisation de la deuxième couche et une activation de dopants à l'aide d'au moins un recuit thermique.

## Description

### DOMAINE TECHNIQUE ET ART ANTÉRIEUR

La présente invention se rapporte au domaine de la microélectronique et plus particulièrement à celui des procédés de fabrication de transistors.

Afin d'améliorer les performances d'un transistor mis en oeuvre sur un substrat de type semi-conducteur sur isolant, par exemple de type SOI (SOI pour *« silicon on insulator »* ou *« silicium sur isolant »*), il est connu de réaliser des blocs de source et de drain surélevés, c'est à dire qui sont réalisés au moins en partie dans des blocs semi-conducteurs qui s'étendent de part et d'autre d'une grille, au-dessus d'une couche semi-conductrice superficielle du substrat dans laquelle le canal du transistor est prévu.

Dans le même temps, il peut s'avérer nécessaire ou tout du moins préférable de fabriquer des transistors en utilisant un budget thermique le plus faible possible afin de ne pas détériorer leurs performances.

Un dopage de blocs de source et de drain surélevés à faible budget thermique peut être en particulier envisagé.

Pour cela, un procédé peut consister tout d'abord à effectuer une ou plusieurs implantations d'ions dont au moins une implantation de dopants, ces implantations ayant tendance à endommager la structure cristalline du matériau semi-conducteur dopé et à le rendre amorphe. Puis, une recristallisation conduisant à une activation des dopants dans le matériau semi-conducteur amorphe peuvent être ensuite réalisées à basse température, en particulier inférieure à 650 °C. Ce procédé est connue sous la dénomination de SPER pour *« Solid-Phase Epitaxial Recrystallisation ».*

Si l'on amorphise par implantation les blocs de source et de drain sur toute leur épaisseur, c'est-à-dire jusqu'à une couche isolante du substrat semi-conducteur sur isolant, une recristallisation monocristalline du matériau rendu amorphe sera impossible à mettre en oeuvre.

Pour résoudre ce problème, il est prévu dans le document EP2840594 A1, de réaliser une implantation ionique enterrée des blocs de source et de drain de telle sorte à former une région amorphe inférieure située sur une zone supérieure dont la structure cristalline a été conservée. Puis, on effectue une recristallisation de cette région inférieure en se servant de la zone cristalline supérieure comme zone de départ de fronts de recristallisation.

On peut alternativement réaliser une implantation ionique des blocs de source et de drain de telle sorte à former une zone supérieure amorphe tout en gardant une région inférieure dont on conserve la structure cristalline, puis, effectuer une recristallisation de la zone supérieure en se servant de la région inférieure cristalline comme région de départ de fronts de recristallisation. Mais dans ce cas, cela peut nécessiter de conserver une épaisseur importante de germe de matériau cristallin à proximité de la couche isolante du substrat afin de permettre de bien recristalliser la zone supérieure amorphe.

Il se pose le problème de trouver un nouveau procédé permettant le dopage des régions de source et de drain d'un transistor qui soit amélioré vis-à-vis d'inconvénients décrits ci-dessus.

### EXPOSÉ DE L'INVENTION

Un mode de réalisation de la présente invention prévoit un procédé pour former des blocs de source et de drain dopés d'un transistor comprenant des étapes consistant à :
- prévoir une structure comprenant des blocs semi-conducteurs destinés à réaliser des blocs de source et de drain disposés de part et d'autre d'une zone semi-conductrice dans laquelle un canal du transistor est apte à être réalisé, les blocs semi-conducteurs comportant une première couche à base d'un premier matériau semi-conducteur cristallin surmontée d'une deuxième couche à base d'un deuxième matériau semi-conducteur cristallin différent du premier matériau semi-conducteur,
- rendre amorphe et doper la deuxième couche à l'aide d'une ou plusieurs implantation(s), l'amorphisation étant une amorphisation sélective du deuxième matériau semi-conducteur réalisée de sorte à conserver la structure cristalline du premier matériau semi-conducteur,
- effectuer une recristallisation de la deuxième couche et une activation de dopants à l'aide d'au moins un recuit thermique.

Une amorphisation sélective de la deuxième couche par rapport à la première couche peut être réalisée en choisissant de manière adéquate le premier matériau semi-conducteur, le deuxième matériau semi-conducteur, ainsi que les paramètres de la ou des implantation(s), en particulier la température, l'espèce implantée, la dose, l'énergie et le courant d'implantation.

Pour permettre une amorphisation sélective on choisit de préférence le premier matériau semi-conducteur à base de Si₁₋ₓGeₓ (avec 1 > x ≥ 0), tandis que le deuxième matériau semi-conducteur est à base de Si_{1-y}Ge_{y} avec y > 0, les concentrations x et y en Ge étant telles que : |y - x| ≥ 0.1

L'interface entre la première couche et la deuxième couche correspondant ici à l'interface entre région rendue amorphe et la zone dont la structure cristalline a été conservée.

Par le biais de l'amorphisation sélective, on définit de manière précise cette interface entre région amorphe et zone cristalline et on peut obtenir une interface sensiblement plane, et permettre par la suite de bien recristalliser la deuxième couche. L'interface entre la première couche et la deuxième couche sert ici de zone de départ au front de recristallisation.

La deuxième couche est de préférence formée sur des régions amincies de la première couche. On peut ainsi mettre en oeuvre un dopage au plus près des zones situées sous les espaceurs et réaliser un transistor avec des résistances d'accès au canal réduites.

Ladite structure peut comprendre un bloc de grille et des premiers espaceurs isolants agencés de part et d'autre du bloc de grille et reposant sur une zone donnée de la première couche. Dans ce cas, le procédé peut comprendre en outre préalablement à l'étape consistant à prévoir la structure, des étapes consistant à :
- amincir la première couche de part et d'autre de la zone donnée,
- former la deuxième couche sur la première couche.

Avantageusement, après amincissement de la première couche et préalablement à la formation de la deuxième couche, le procédé peut comprendre une étape consistant à :
- retirer une épaisseur des régions de la première couche de part et d'autre des espaceurs et d'une partie de la zone donnée située en regard des espaceurs.

On peut ainsi former une deuxième couche plus proche de la zone de canal, et par la suite avoir des zones d'accès au canal de résistance réduite.

Selon une possibilité de mise en oeuvre du procédé, la formation de la deuxième couche peut comprendre au moins une première croissance par épitaxie du deuxième matériau semi-conducteur jusqu'au moins au niveau d'une face supérieure de la zone donnée de la première couche sur laquelle repose une grille du transistor.

Selon une possibilité de mise en oeuvre du procédé, après la première croissance par épitaxie on peut réaliser une amorphisation du deuxième matériau semi-conducteur sélective vis-à-vis du premier matériau semi-conducteur.

Selon une possibilité de mise en oeuvre du procédé, après la première croissance par épitaxie on peut réaliser une deuxième croissance par épitaxie de manière à former une troisième couche semi-conductrice sur la deuxième couche semi-conductrice.

Selon une possibilité de mise en oeuvre du procédé, après la première croissance par épitaxie et préalablement à la deuxième croissance par épitaxie, on peut former des deuxièmes espaceurs isolants contre les premiers espaceurs isolants.

Selon une possibilité de mise en oeuvre du procédé, durant la deuxième croissance par épitaxie, on peut effectuer un dopage *in-situ* de la troisième couche semi-conductrice.

En variante, après la deuxième croissance par épitaxie on peut réaliser une amorphisation sélective de la troisième couche semi-conductrice et du deuxième matériau semi-conducteur vis-à-vis du premier matériau semi-conducteur.

Selon une possibilité de mise en oeuvre du procédé, après la première croissance par épitaxie et préalablement à la deuxième croissance par épitaxie on effectue un dopage du deuxième matériau semi-conducteur par amorphisation et recristallisation.

De préférence, afin d'obtenir une bonne sélectivité d'amorphisation, le premier matériau semi-conducteur a une concentration x en Ge inférieure à 25 %, tandis que le deuxième matériau semi-conducteur a une concentration supérieure à 35 % en Ge.

Selon une possibilité de mise en oeuvre du procédé lorsque le transistor est de type NMOS, le premier matériau semi-conducteur peut être à base de Si tandis que le deuxième matériau semi-conducteur est à base Si_{1-y}Ge_{y}, avec 5% < y < 15%.

Dans ce cas, une troisième couche semi-conductrice peut être formée sur la deuxième couche semi-conductrice et prévue à base d'un matériau, tel que du Si:C, adapté pour induire une contrainte en tension dans la zone de canal.

Selon une autre possibilité de mise en oeuvre du procédé, lorsque le transistor est de type PMOS, le premier matériau semi-conducteur peut être à base de Si tandis que le deuxième matériau semi-conducteur est à base Si_{1-y}Gey avec y > 20 %, ou bien le premier matériau peut être à base de Si₁₋ₓGeₓ avec x < 25% et le second matériau est du Si_{1-y}Ge_{y} avec y > 35 %.

Dans ce cas, une troisième couche semi-conductrice peut être formée sur la deuxième couche semi-conductrice et prévue à base d'un matériau, tel que du Si_{1-z}Ge_{z} avec y ≤ z, adapté pour induire une contrainte en compression dans la zone de canal.

Un procédé de réalisation d'un transistor peut ainsi comprendre un procédé de réalisation de bloc de source et de drains tels que définis plus haut.

Un mode de réalisation de l'invention prévoit également un dispositif microélectronique mis en oeuvre à l'aide d'un procédé tel que défini plus haut.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A-1D illustrent un premier exemple de procédé suivant un mode de réalisation de l'invention dans lequel on forme des blocs de source et de drain dopés pour un transistor de type PMOS, cette formation comprenant une amorphisation sélective d'une couche semi-conductrice vis-à-vis d'une autre couche semi-conductrice sur laquelle elle est empilée afin de définir précisément une interface entre une zone amorphisée et une région cristalline ;
- la figure 2 illustre un deuxième exemple de procédé adapté à la mise en oeuvre de blocs de source et de drain dopés pour un transistor de type NMOS, l'amorphisation sélective étant réalisée sur un empilement de matériaux semi-conducteurs différent de celui du premier exemple de procédé ;
- les figures 3A-3D illustrent un mode de réalisation avantageux dans lequel on effectue un retrait d'une portion de couche semi-conductrice superficielle de part et d'autre des espaceurs du transistor afin d'abaisser l'interface entre zone amorphisée et région cristalline et pouvoir effectuer un dopage au plus près des zones d'accès au canal ;
- les figures 4A-4E illustrent une variante de réalisation dans laquelle on
   on effectue un retrait d'une portion de couche semi-conductrice superficielle sous les espaceurs afin de rapprocher l'interface entre zone amorphisée et région cristalline des zones d'accès au canal ;
- les figures 5A-5B illustrent une variante de réalisation de l'exemple de procédé des figures 4C-4E dans laquelle on effectue une amorphisation sélective de plusieurs couches semi-conductrices après avoir formé des espaceurs isolants supplémentaires ;
- les figures 6A-6B illustrent une variante de réalisation dans laquelle on effectue une amorphisation sélective d'une couche semi-conductrice préalablement à une formation d'espaceurs isolants supplémentaires ;
- la figure 7 illustre une variante de réalisation de l'exemple de procédé des figures 4A-4E ;
- la figure 8 illustre un exemple particulier de réalisation dans lequel on effectue une amorphisation sélective d'une couche semi-conductrice à base de Si :C et une couche à base de SiGe vis-à-vis d'une couche superficielle en Silicium dans laquelle le canal du transistor est réalisé ;
- la figure 9 illustre un procédé dans lequel la deuxième épitaxie est dopée *in-situ* de couches semi-conductrices destinées à former des blocs de source et de drain de transistor;
Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

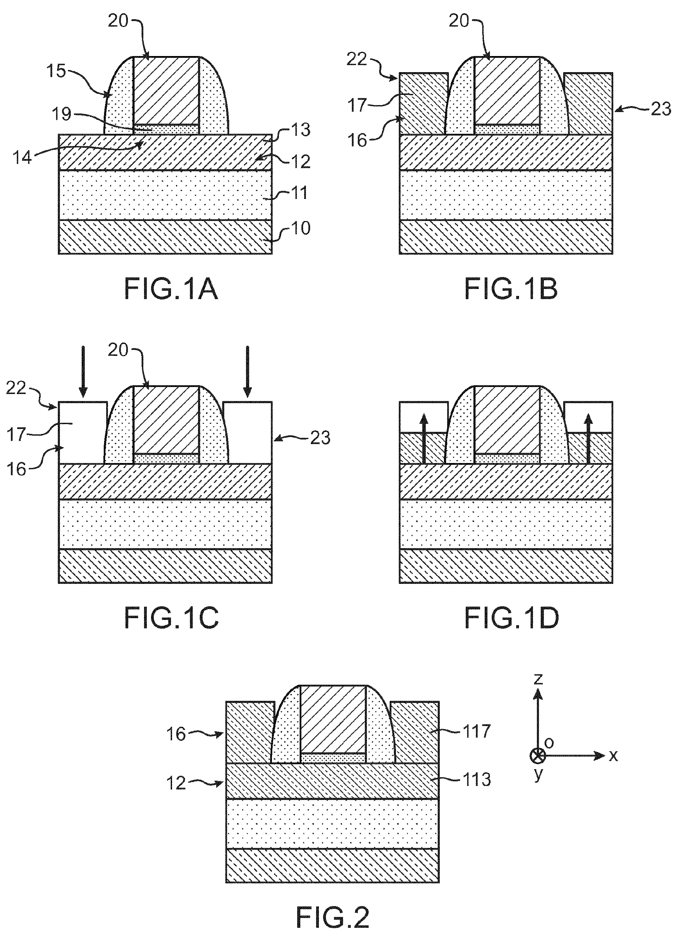

Un premier exemple de procédé de réalisation de blocs de source et de drain dopés d'un transistor va à présent être décrit en liaison avec les figures 1A-1D.

Dans cet exemple, le transistor que l'on fabrique est de type PMOS.

La figure 1A illustre une structure de départ possible de cet exemple de procédé. Cette structure peut être formée à partir d'un substrat de type semi-conducteur sur isolant, par exemple de type SiGeOI, qui comprend une couche de support 10 semi-conductrice, une couche isolante 11 qui peut être à base d'oxyde de silicium et est disposée sur et en contact de la couche de support 10. La couche isolante 11 du substrat peut être en particulier une couche de type BOX (BOX pour *« Burried Oxide »*) ou TBOX (TBOX pour *« Thin Burried Oxide »).* Le substrat comporte également une couche semi conductrice 12 superficielle à base d'un premier matériau semi-conducteur 13 cristallin.

La couche semi conductrice superficielle 12 est située sur, et en contact avec, la couche isolante 11 du substrat. La couche semi-conductrice 12 superficielle peut avoir une épaisseur comprise par exemple entre 3 et 40 nm, en particulier entre 4 nm et 10 nm ou de l'ordre de 6 nm. La couche semi-conductrice 12 superficielle peut être à base de Si₁₋ₓGeₓ avec x > 0 et en particulier inférieur à 25%, par exemple de l'ordre de 15 à 20 %.

Des étapes de dépôt d'une couche de diélectrique 19 de grille et d'une ou plusieurs couches de matériau(x) de grille, puis de gravure de ces couches afin de réaliser un bloc 20 de grille en regard d'une zone 14 de la couche semi-conductrice superficielle 12 destinée à former un canal pour le transistor, sont ensuite effectuées. Le bloc 20 de grille du transistor peut être formé d'un empilement comprenant une couche d'oxyde sur laquelle repose une couche métallique, par exemple à base de TiN, sur laquelle repose une couche semi-conductrice, par exemple à base de polysilicium. Des espaceurs isolants 15, par exemple à base de nitrure de silicium sont également formés contre les flancs latéraux du bloc de grille 20 et reposent sur la couche semi-conductrice 12 superficielle.

Puis, à partir de la structure illustrée sur la figure 1A, on fait croitre une couche 16 à base d'un deuxième matériau semi-conducteur 17 cristallin par épitaxie sur la couche semi-conductrice 12 superficielle (figure 1B).

Le deuxième matériau semi-conducteur 17 est différent du premier matériau semi-conducteur 13. Le deuxième matériau semi-conducteur 17 peut être à base de Si_{1-y}Ge_{y} avec une concentration y en Germanium différente de celle du premier matériau semi-conducteur cristallin. Le deuxième matériau semi-conducteur 17 peut avoir une concentration y en Ge de préférence supérieure à 35% et par exemple de l'ordre de 40 à 50 %.

On forme ainsi avec cette couche semi-conductrice 12, des blocs semi-conducteurs destinés à former des blocs de source et de drain surélevés disposés de part et d'autre de la zone de canal et des espaceurs 15. L'épaisseur de la couche 16 à base du deuxième matériau semi-conducteur 17 peut être comprise par exemple entre 10 et 30 nm.

Ensuite, on réalise une amorphisation de la couche 16 à base du deuxième matériau semi-conducteur cristallin 17 à l'aide d'une ou plusieurs implantations ioniques.

La différence y-x de concentration en Ge entre les deux couches semi-conductrices 12 et 17 est choisie de sorte que, lors de l'amorphisation avec une espèce ionique donnée, une dose donnée, énergie donnée, un courant d'implantation donné et une température donnée, seule la couche 16 à base du deuxième matériau semi-conducteur 17 plus riche en Ge est amorphisée. La couche 12 à base du premier matériau semi-conducteur 13 correspond alors à une région laissée cristalline. On réalise donc une amorphisation sélective en choisissant x, y, la dose implantée, l'énergie d'implantation, le courant d'implantation, la température d'implantation et l'ion implanté.

Une telle sélectivité d'amorphisation est évoquée dans le document : « Amorphization threshold in Si implanted strained SiGe alloy layers », de T.W. Simpson et al., EMRS 94, Boston.

L'homme du métier saura obtenir les courbes expérimentales pour déterminer la différence de concentration en Ge, en fonction de la valeur de la dose et de la température pour obtenir une amorphisation sélective.

Pour permettre d'obtenir une bonne sélectivité d'amorphisation, la différence de concentration en valeur absolue |y - x| entre le premier matériau semi-conducteur cristallin 13 et le deuxième matériau semi-conducteur cristallin 17 est de préférence supérieure ou égale à 10%.

Le fait de travailler à plus haute température peut permettre de gagner en sélectivité.

L'homme du métier saura obtenir des courbes expérimentales à différence de concentration en Ge donnée, la dose, l'énergie et la température d'implantation pour obtenir une amorphisation sélective.

A dose et énergie fixées, la température à laquelle le substrat est placé peut être en particulier adaptée afin de modifier la sélectivité d'amorphisation.

Le document de Simpson référencé ci-dessus donne par exemple des fenêtres de température et de dose pour permettre, pour une énergie donnée, d'amorphiser sélectivement du Si_{1-y}Ge_{y} avec y = 0.15 par rapport à du Si ou pour permettre, pour une énergie donnée, d'amorphiser sélectivement du Si_{1-y}Ge_{y} avec y = 0.29 par rapport à du Si.

A l'aide d'une telle amorphisation sélective, on obtient une interface entre la zone amorphisée et la région restée cristalline qui est bien définie et correspond à l'interface des deux couches 12 et 16. L'interface entre zone amorphise et région cristalline est donc précisément localisée et présente une rugosité réduite.

Selon une possibilité de mise en oeuvre du procédé d'amorphisation sélective, la ou les implantations du deuxième matériau semi-conducteur 17 peut ou peuvent être réalisée(s) à l'aide d'au moins une espèce dopante tel que par exemple du P ou de l'As. Dans ce cas, on dope le deuxième matériau semi-conducteur 17 en même temps qu'on rend ce matériau amorphe.

En variante, on réalise une amorphisation sélective du deuxième matériau semi-conducteur 17 à l'aide d'une ou plusieurs implantation d'espèce(s) non-dopante par exemple tel que du Ge ou du Si. Dans ce cas, pour doper le deuxième matériau semi-conducteur 17 on peut ensuite, ou au préalable, effectuer une ou plusieurs autres implantations à l'aide d'espèce(s) dopante(s). Cette autre ou ces autres implantation(s) de dopants peut ou peuvent être réalisée(s) à haute température afin d'optimiser le profil de dopants sans réaliser d'amorphisation.

Il est également possible de réaliser l'amophisation sélective et d'obtenir un profil d'amorphisation partiellement à l'aide d'au moins une première implantation d'une première espèce, par exemple une espèce dopante, ce profil d'amorphisation étant ensuite modifié à l'aide d'au moins une autre implantation d'une autre espèce, par exemple une espèce non-dopante.

Lors de la ou des implantations, un ou plusieurs transistors (non représentés) d'un type différent de celui dont on décrit ici la fabrication, par exemple un transistor de type N, peuvent être protégés à l'aide d'un masquage (non représenté). Ce masquage est de préférence à base d'un matériau qui peut être retiré après la ou les implantations. Un exemple d'un tel matériau est le carbone amorphe avec une concentration atomique en hydrogène inférieure à 15%. Ce matériau peut être retiré à l'aide d'un plasma à base d'oxygène et ce sans endommager les autres couches et en particulier des couches d'oxyde de silicium, de nitrure de silicium et les couches semi-conductrices. On peut en variante utiliser un masquage en résine ou sous forme d'un masque dur à base d'oxyde de silicium ou de nitrure de silicium ou composé d'un empilement de couches d'oxyde de silicium et de nitrure de silicium.

Après la ou les implantations, on effectue ensuite une recristallisation de la zone amorphisée. Cette recristallisation conduit à une activation des dopants (figure 1D).

La recristallisation et l'activation peuvent être réalisées à l'aide d'au moins un recuit thermique, en particulier tel que mis en oeuvre dans un procédé de type SPER pour « Solid-Phase Epitaxial Recrystallisation ».

Le recuit thermique peut être effectué à une température choisie de manière à permettre de réaliser la recristallisation conjointement avec l'activation des dopants. La température de recuit peut être une température basse, i.e. inférieure à 600°C, et comprise par exemple entre 400°C et 600°C.

Les zones de la couche superficielle 12 qui se trouvent en contact avec la deuxième couche 16 servent de départ à un front de recristallisation (indiqué par des flèches sur la figure 1D) qui se déplace dans une direction verticale vers le haut (i.e. correspondant à la direction et au sens de l'axe z du repère [O,x,y,z]).

En variante de l'exemple qui vient d'être décrit précédemment, on peut réaliser un transistor PMOS avec un empilement différent de matériaux semi-conducteurs comportant une couche superficielle 12 de Si et un deuxième matériau semi-conducteur 17 à base de Silicium Germanium ayant une importante concentration en Germanium, par exemple comprise entre 25 et 40 %.

La figure 2 illustre une autre structure de départ pour réaliser un procédé tel que décrit précédemment mais dans lequel le transistor que l'on réalise est cette fois de type NMOS.

Dans ce cas, la couche semi-conductrice 12 superficielle est à base d'un matériau semi-conducteur cristallin 113 différent de celui du premier exemple de procédé, par exemple du silicium ou du silicium contraint. La couche semi-conductrice 12 superficielle peut être alors la couche superficielle d'un substrat SOI ou sSOI (pour « strained SOI ») sur lequel on forme une deuxième couche semi-conductrice 16 à base d'un matériau semi-conducteur 117 différent de celui de la couche superficielle 12. Le matériau semi-conducteur 117 peut être par exemple du Si_{1-y}Ge_{y} avec y>0.

Comme dans le premier exemple de procédé, une différence de concentration en Ge est prévue entre les deux couches semi-conductrices 12 et 16. On peut ainsi réaliser une amorphisation sélective de la couche 16 de Si_{1-y}Ge_{y} plus riche en Ge, tandis que la couche 12 de Si correspond alors à la région laissée cristalline.

Dans le cas où l'on réalise une structure de transistor NMOS, le matériau semi-conducteur 117 est formé avec une concentration y en Ge suffisamment faible pour ne pas induire de contrainte compressive intempestive dans la zone de canal, mais suffisamment importante pour permettre d'obtenir une sélectivité d'amorphisation avec la couche semi-conductrice 12 superficielle. La concentration y en Ge du matériau semi-conducteur 117 peut être comprise par exemple entre 5 et 10%.

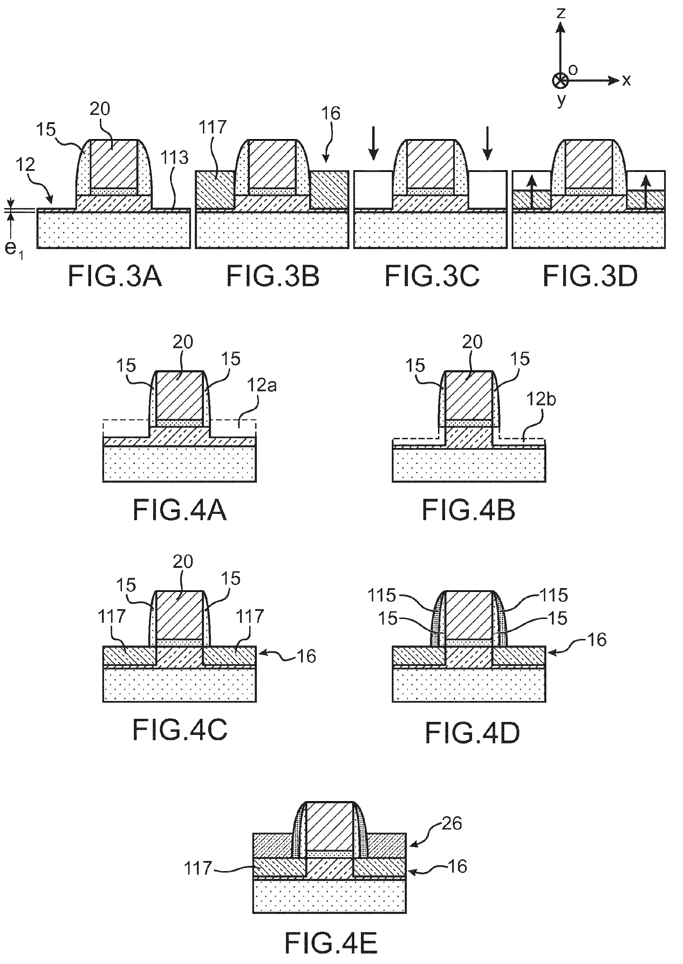

Une variante des exemples de réalisation précédemment décrits est donnée sur les figures 3A-3D.

Pour cette variante, on effectue tout d'abord un amincissement de portions de la couche semi-conductrice superficielle 12 situées de part et d'autre de la grille 20 et des espaceurs 15. Cet amincissement peut être effectué par exemple par gravure sèche à l'aide d'un plasma. L'amincissement est réalisé de manière à conserver une épaisseur e₁ (mesurée parallèlement à la direction définie par l'axe z du repère [O,x,y,z] sur la figure 3A) de matériau semi-conducteur 117 qui peut être très faible, par exemple de l'ordre de 1 nm.

Ensuite, on fait croitre la deuxième couche 16, par épitaxie de matériau semi-conducteur 117, par exemple du SiGe sur la première couche 12 (figure 3B). En cas d'épaisseur e₁ très fine de la couche semi-conductrice superficielle 12, on peut prévoir de réduire la température d'épitaxie afin d'éviter un phénomène de démouillage de la deuxième couche 16. Le document "Agglomeration control during the selective epitaxial growth of Si raised sources and drains on ultra-thin silicon-on-insulator substrates" de C. Jahan, O. Faynot, L. Tosti, et J.M. Hartmann, Journal of Crystal Growth 280 (2005) 530-538, et en particulier la figure 1b de ce document donne un exemple de gamme de température d'épitaxie que l'on peut choisir en fonction de l'épaisseur d'une couche superficielle 12 en Si que l'on prévoit.

On réalise ensuite une amorphisation sélective de la deuxième couche 16, à l'aide d'une ou plusieurs implantations. L'interface entre la zone amorphe et la région cristalline est alors avantageusement située très proche de la couche isolante 11 du substrat. Cette interface est définie en outre de manière précise et avec une faible rugosité. Un dopage de la deuxième couche 16 est également réalisé par le biais de ces implantations ou d'une ou plusieurs autres étapes d'implantation (figure 3C).

Puis, on effectue un recuit de recristallisation du matériau 117 (figure 3D). L'activation des dopants dans la deuxième couche 16 est obtenue par la recristallisation.

Dans cet exemple de réalisation, la deuxième couche 16 formée sur des portions amincies de la couche superficielle 12 et qui est dopée, est avantageusement située plus proche des régions du transistor situées sous les espaceurs 15 et du canal. On peut ainsi mettre en oeuvre un transistor avec des résistances d'accès au canal réduites. Il est possible avec cette configuration d'augmenter les concentrations de dopants dans une zone proche du canal tout en limitant le risque de ne pas arriver à bien recristalliser les régions rendues amorphes.

Une variante de l'exemple de procédé précédemment décrit est donnée sur les figures 4A-4D.

Pour cette variante, on réalise un premier amincissement de la couche superficielle 12, par exemple par gravure anisotrope à l'aide d'un plasma. On retire ainsi des portions 12a (délimitées par des pointillées sur la figure 4A) de la couche superficielle 12 dans des régions situées de part et d'autre des espaceurs 15, tout en conservant intacte la couche superficielle 12 dans une zone située en regard des espaceurs 15 et de la grille 20.

On effectue ensuite un deuxième amincissement de la couche superficielle 12, cette fois de manière à retirer une portion 12b (délimitée par des pointillées sur la figure 4B) de régions de la couche superficielle 12 situées de part et d'autre des espaceurs mais aussi d'une partie de la couche superficielle 12 située en regard des espaceurs 15 tout en conservant intacte la couche superficielle 12 dans une zone située en regard de la grille 20. Ce deuxième amincissement peut être réalisé par gravure isotrope. Cette gravure isotrope peut être effectuée par exemple à l'aide de HCl lorsque la couche superficielle 12 est à base de Si.

Ensuite, on effectue une croissance par épitaxie du deuxième matériau semi-conducteur 117 sur les zones restantes de la couche semi-conductrice superficielle 12 (figure 4C). Cette croissance peut être prolongée jusqu'à atteindre le même niveau que celui d'une face supérieure de la couche superficielle 12 sur laquelle repose la grille 20 du transistor. Autrement dit, on atteint l'épaisseur d'origine de la couche semi-conductrice superficielle 12. Les espaceurs 15 isolants permettent de protéger la grille lors de la croissance du deuxième matériau semi-conducteur 117.

On peut alors ensuite former d'autres espaceurs isolants 115 contre les espaceurs isolants 15. Les espaceurs isolants 115 peuvent être également par exemple à base de nitrure de silicium (figure 4D). Les espaceurs isolants 115 peuvent avoir des dimensions adaptées en fonction de spécifications en termes de capacités parasites tolérables pour la technologie dans laquelle le transistor est réalisé.

Puis, on peut effectuer une deuxième croissance par épitaxie de manière à former une troisième couche semi-conductrice 26. On augmente ainsi l'épaisseur des blocs de source et de drain et on rehausse ainsi la face supérieure des blocs de source et de drain. Cette couche semi-conductrice 26 peut être par exemple à base d'un matériau qui peut être identique au matériau semi-conducteur 117, par exemple à base de Si_{1-y}Ge_{y} (figure 4E).

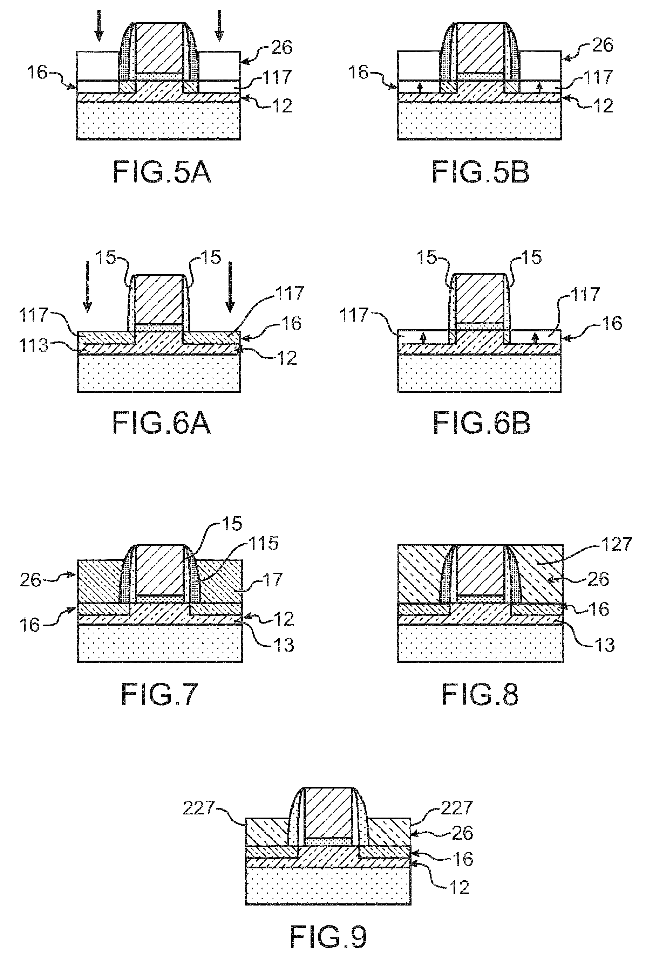

Il est ensuite possible, après cette deuxième croissance, de réaliser l'amorphisation sélective et le dopage des deuxième et troisième couches semi-conductrices 16, 26 à l'aide d'une ou plusieurs implantations (figure 5A).

Puis, une recristallisation du matériau 117 des deuxième et troisième couches semi-conductrices 16, 26 est réalisée (figure 5B).

En variante de l'exemple de réalisation précédent (figures 6A-6B), après la première croissance décrite en liaison avec la figure 4C, on réalise une amorphisation sélective et un dopage du matériau 117 de la deuxième couche 16 (figure 6A).

Puis, on effectue une recristallisation du matériau 117 de la deuxième couche semi-conductrice 26 (figure 6B).

Ensuite, on peut effectuer des étapes semblables à celles décrites en liaison avec les figures 4D-4E de formation des deuxièmes espaceurs 115 et d'une troisième couche semi-conductrice 26.

Il est ensuite possible, après la formation de cette troisième couche semi-conductrice 26 de réaliser une amorphisation sélective et un dopage tel qu'illustré sur les figures 5A-5B, puis d'effectuer une recristallisation du matériau 117 des deuxième et troisième couches semi-conductrices 16, 26.

Pour cette variante, la deuxième couche semi-conductrice 16 peut être donc rendue amorphe puis recristallisée plusieurs fois.

Selon une autre variante, on peut partir d'une structure semblable à celle décrite en liaison avec la figure 4A mais dotée d'une couche superficielle 12 est à base de Si₁₋ₓGeₓ. On forme ensuite une deuxième couche semi-conductrice 16 à base de Si_{1-y}Ge_{y}, puis une troisième couche semi-conductrice 26 à base de Si_{1-y}Ge_{y}. On peut alors obtenir une structure telle que représentée sur la figure 7 à partir de laquelle on peut réaliser une amorphisation du deuxième matériau semi-conducteur 17 sélective vis-à-vis du matériau semi-conducteur 13 de concentration en Ge plus faible.

En variante de l'étape décrite précédemment en liaison avec la figure 4E, il est également possible de réaliser la deuxième croissance par épitaxie pour former la troisième couche semi-conductrice 26 à base d'un autre matériau semi-conducteur 127 différent du matériau semi-conducteur 117 de la deuxième couche semi-conductrice 16 (figure 8). Cet autre matériau semi-conducteur 127 peut être adapté pour avoir un paramètre de maille différent de celui de la deuxième couche afin d'induire une contrainte dans la zone de canal du transistor. Dans le cas d'un transistor de type N, cet autre matériau semi-conducteur 127 peut être adapté pour induire une contrainte en tension, par exemple du Silicium dopé au carbone (Si:C).

Selon une variante des exemples précédemment décrits, après avoir réalisé la première croissance par épitaxie pour former la deuxième couche semi-conductrice 16, on peut réaliser un dopage par amorphisation sélective puis recristallisation de la deuxième couche semi-conductrice 16.

On peut effectuer ensuite une deuxième croissance par épitaxie d'une troisième couche 26 de matériau semi-conducteur 227 tout en dopant ce matériau semi-conducteur 227. On réalise ainsi un dopage *in situ* de la troisième couche 26. Le matériau semi-conducteur 227 de la troisième couche 26 peut être par exemple du silicium Germanium dopé au Bore (SiGe:B) lorsque deuxième couche 16 est à base de SiGe et que la couche superficielle 12 est en Si. On peut alors obtenir une structure telle qu'illustrée sur la figure 9.

Selon une autre variante (non représentée) de l'un ou l'autre des exemples des réalisation illustrés sur les figures 5A ou 6A, on peut réaliser une implantation à l'aide d'un faisceau incliné par rapport à une normale à la couche semi-conductrice superficielle 12. Cela peut permettre d'amorphiser et de doper ou de mieux amorphiser et doper des zones du matériau 117 situées sous les espaceurs.

L'un ou l'autre des procédés qui viennent d'être décrits s'appliquent par exemple à la réalisation de transistors de type FDSOI (FDSOI pour « *Fully Depleted Silicon On Insulator »*) UTBB (pour « *Ultra Thin Body and Box »).*

L'un ou l'autre des procédés qui viennent d'être décrits permet de mettre en oeuvre une fabrication de transistors utilisant un faible budget thermique, par exemple inférieur à 650°C.

## Revendications

1. Procédé de réalisation d'un dispositif microélectronique doté d'au moins un transistor formé sur un substrat de type semi-conducteur sur isolant comprenant des étapes consistant à :
- prévoir une structure comprenant, sur une couche isolante (11) d'un substrat semi-conducteur sur isolant : une première couche semi-conductrice à base d'un premier matériau semi-conducteur cristallin (13, 113), le premier matériau semi-conducteur (13, 113) étant à base de Si₁₋ₓGeₓ(avec x ≥ 0), la première couche comportant une zone donnée dans laquelle un canal du transistor est apte à être réalisé, des blocs semi-conducteurs étant disposés de part et d'autre de ladite zone destinés à former des blocs de source et de drain, ladite structure comportant en outre un bloc de grille (20) et des premiers espaceurs isolants (15) agencés de part du bloc de grille et reposent sur ladite zone donnée de la première couche, puis
- amincir la première couche (12) de part et d'autre de ladite zone donnée,
- formation d'une deuxième couche (16) à base d'un deuxième matériau semi-conducteur cristallin (17, 117) différent du premier matériau semi-conducteur sur des régions amincies de la première couche (12) de sorte à compléter la formation desdits blocs de source et de drain, le deuxième matériau semi-conducteur (17, 117) étant à base de Si_{1-y}Ge_{y} avec 0 ≤ x < y, avec y-x > 0.1,
puis
- rendre amorphe et doper la deuxième couche (16) à l'aide d'une ou plusieurs implantation(s), le premier matériau, le deuxième matériau, et la ou les implantation(s) étant prévus de sorte à réaliser une amorphisation sélective du deuxième matériau semi-conducteur tout en conservant la structure cristalline du premier matériau semi-conducteur, une interface entre la première couche et la deuxième couche correspondant à une interface entre une région rendue amorphe et une région dont la structure cristalline a été conservée,
- effectuer une recristallisation de la deuxième couche ainsi qu'une activation de dopants à l'aide d'au moins un recuit thermique.

2. Procédé selon la revendication 1, comprenant en outre après amincissement de la première couche (12) et préalablement à la formation de la deuxième couche (16), une étape consistant à :
- retirer une épaisseur des régions de la première couche (12) de part et d'autre des espaceurs (15) et d'une partie de la zone donnée située en regard des espaceurs (15).

3. Procédé selon l'une des revendications 1 ou 2, dans lequel la formation de la deuxième (16) couche comprend au moins une première croissance par épitaxie du deuxième matériau semi-conducteur (117) jusqu'au moins le niveau d'une face supérieure de la zone donnée de la première couche (12) sur laquelle repose le bloc de grille.

4. Procédé selon la revendication 3, dans lequel après la première croissance par épitaxie on réalise une amorphisation du deuxième matériau semi-conducteur (117) sélective vis-à-vis du premier matériau semi-conducteur (113).

5. Procédé selon l'une des revendication 3 ou 4, dans lequel après la première croissance par épitaxie on réalise une deuxième croissance par épitaxie de manière à former une troisième couche semi-conductrice (26) sur la deuxième couche semi-conductrice (16).

6. Procédé selon la revendication 5, dans lequel après la première croissance par épitaxie et préalablement à la deuxième croissance par épitaxie on forme des deuxièmes espaceurs isolants (115) contre les premiers espaceurs isolants (15).

7. Procédé selon l'une des revendication 5 ou 6, dans lequel durant la deuxième croissance par épitaxie on effectue un dopage *in-situ* de la troisième couche semi-conductrice (26).

8. Procédé selon l'une des revendication 5 à 7, dans lequel après la deuxième croissance par épitaxie on réalise une amorphisation sélective du matériau de la troisième couche semi-conductrice (26) et du deuxième matériau semi-conducteur (117) vis-à-vis du premier matériau semi-conducteur (13).

9. Procédé selon l'une des revendications 5 à 8, dans lequel après la première croissance par épitaxie et préalablement à la deuxième croissance par épitaxie, on effectue un dopage du deuxième matériau semi-conducteur, la ou les implantations étant ensuite réalisées après la deuxième croissance par épitaxie de manière à rendre amorphe et à doper la troisième couche semi-conductrice et la deuxième couche semi-conductrice.

10. Procédé selon l'une des revendications 1 à 9, dans lequel le transistor est de type NMOS, le premier matériau semi-conducteur (13) étant à base de Si tandis que le deuxième matériau semi-conducteur (17) est à base Si_{1-y}Ge_{y}, avec 5% < y < 15%.

11. Procédé selon la revendication 10, dans lequel une troisième couche semi-conductrice (26) est formée sur la deuxième couche semi-conductrice (16), la troisième couche étant à base de Si:C.

12. Procédé selon l'une des revendications 1 à 9, dans lequel le transistor est de type PMOS, le premier matériau semi-conducteur (13) étant à base de Si tandis que le deuxième matériau semi-conducteur (17) est à base Si_{1-y}Gey avec y > 20 %,
ou
le premier matériau est à base de Si₁₋ₓGeₓ avec x < 25% et le second matériau est du Si_{1-y}Ge_{y} avec y > 35 %.

13. Procédé selon la revendication 12, dans lequel une troisième couche semi-conductrice (26) est formée sur la deuxième couche semi-conductrice (16), la troisième couche étant à base de Si_{1-z}Ge_{z} avec y ≤ z.
